# EUROPÄISCHE PATENTSCHRIFT

(11) **EP 3 026 366 B1**
(45) Veröffentlichungstag und Bekanntmachung des Hinweises auf die Patenterteilung: **19.12.2018**
(21) Anmeldenummer: 15195275.1
(22) Anmeldetag: 19.11.2015
(51) Int. Cl.: F24S 25/10, H01L 31/0392, H02S 30/20

(54) **SOLARMODULKONSTRUKTION**
SOLAR MODULE ARRANGEMENT
AGENCEMENT DE MODULE SOLAIRE

(30) Priorität: 20.11.2014 CH 17912014
(43) Veröffentlichungstag der Anmeldung: 01.06.2016
(73) Patentinhaber: S. E. Track AG, 6300 Zug (CH)
(72) Erfinder: Ott, Christoph, 3076 Worb (CH)
(74) Vertreter: BOVARD AG

(56) Entgegenhaltungen:
- EP-A1- 2 631 389
- EP-A2- 0 867 946
- EP-A2- 2 042 822
- DE-A1- 2 738 857
- DE-U-202010 003 130
- DE-U-202011 109 461
- DE-U1-202009 017 110
- US-A- 5 829 427
- US-A1- 2009 173 377
- US-A1- 2012 118 353
- US-A1- 2013 153 006
- DATABASE WPI Section PQ, Week 201278 Thomson Scientific, London, GB; Class Q45, AN 2012-Q07686 XP002740551, -& JP 2012 224982 A (FUJIW) 15. November 2012 (2012-11-15)

## Beschreibung

Die vorliegende Erfindung betrifft eine Solarmodulkonstruktion und ein Solarmodulfeld für photovoltaisch genutzte Flächen, z. B. an Baukonstruktionen, an oder über Bahninfrastrukturen, Gebäuden, freien Flächen in der Natur, etc. Insbesondere betrifft die Erfindung eine dreidimensionale, modular aufgebaute Solarmodulkonstruktion.

Zur Umsetzung von Sonnenenergie in elektrische Energie werden zunehmend freie Flächen mit Solarmodulen bestückt. Beispielsweise werden Solarpaneele auf Dachkonstruktionen, Wandflächen und sogar auf vormals landwirtschaftlich genutzten Flächen angebracht und derart zur Sonne ausgerichtet, dass im Tagesverlauf möglichst viel Sonnenenergie erfasst und umgesetzt werden kann. Hierfür sind diverse Konstruktionen bekannt, mit welchen eine optimale Winkeleinstellung der Solarpaneele und eine flächendeckende Anordnung einer Vielzahl von Solarpaneelen durchgeführt werden kann. Zur weiteren Optimierung der Erfassung der Sonnenenergie sind z. B. drehbare Konstruktionen bekannt, welche die Solarpaneele fortlaufend nach dem Stand der Sonne ausrichten. Auch ist es bekannt Konstruktionen zu verwenden, welche nebeneinander liegende Paneele in unterschiedliche Richtungen ausrichten, so dass im Tagesverlauf unterschiedliche Paneele optimal zur Sonne orientiert sind, ohne die Paneele bewegen zu müssen.

Derartige Konstruktionen sind oft komplex im Aufbau und aufwendig in der Wartung. Gleichwohl sind die Solarpaneele oft nicht vollständig in einem optimalen Winkel ausgerichtet. Ferner besteht das Problem, dass sich die einzelnen Paneele gegenseitig beschatten und die Ausbeute an elektrischer Energie vermindern. Von einander beabstandete Solarpaneele oder Reihen von Solarpaneele benötigen viel Platz und lassen einen Zwischenraum ungenutzt.

In der WO 2012/172296 ist beispielsweise eine Konstruktion gezeigt, bei der eine Trägerstruktur für Solareinheiten halbkugelförmig ausgebildet ist. Auf dem halbkugeligen Träger ist eine Vielzahl von Solareinheiten aufgesetzt, die eine vierseitige Pyramidenform aufweisen. Die vierseitigen Solarpyramiden sind in Reihen angeordnet und überspannen den gesamten Träger. Zur Abdeckung grösserer Flächen können mehrere solcher halbkugeligen Träger nebeneinander angeordnet werden. Auch bei dieser Konstruktion besteht das Problem, dass im Verhältnis zur mit Solareinheiten bedeckten Fläche ein grosser Teil der photovoltaisch aktiven Flächen der Solareinheiten nicht gewinnbringend ausgerichtet ist. Ferner ist die Montage und die Wartung einer solchen Trägerkonstruktion kompliziert. Auch können die Abmessungen einer mit dieser Konstruktion versehenen, photovoltaisch genutzten Fläche nur sehr eingeschränkt an die Gestalt einer zur Verfügung stehenden Fläche angepasst werden.

In US 5 829 427 A ist eine Solarmodulkonstruktion mit einem Nachsteuersystem beschrieben. Photovoltaische Sonnenkollektoren sind an einem ausrichtbaren pyramidenförmigen Aufbau an einer Seite angeordnet, wobei die anderen Seiten des Aufbaus einen Windschutz bereitstellen.

US 2009/0173377 A1 bezieht sich auf ein leichtgewichtiges und biegsames Material, beispielsweise eine Zelthülle, wobei das Material einen Schichtaufbau umfasst mit einer äusseren photovoltaischen Solarschicht, einer mittleren Batterieschicht und einer inneren lichtemittierenden Diodenschicht.

In US 2013/0153006 A1 wird ein photovoltaisches Energiesystem beschrieben, umfassend eine Vielzahl von an aufblasbaren Tragrahmen angeordnete flexible Platten, an welche jeweils eine Vielzahl von photovoltaischen Zellen angeordnet sind.

Es ist daher eine Aufgabe der vorliegenden Erfindung eine Konstruktion für Solarmodule bereitzustellen, die einen hohen Wirkungsgrad der Solarmodule ermöglicht, einfach im Aufbau und der Montage ist und eine effiziente Raumnutzung ermöglicht. Weiter ist es eine Aufgabe der vorliegenden Erfindung ein Feld von Solarmodulen zur Verfügung zu stellen, das in einfacher Weise an bestehende Verhältnisse angepasst werden kann, an bereits anderweitig genutzten Flächen vorgesehen werden kann, platzsparend ist und eine einfache Wartung erlaubt.

Diese Aufgabe wird von der Erfindung durch eine Solarmodulkonstruktion nach Anspruch 1 und ein Solarmodulfeld mit solchen Solarmodulkonstruktionen nach Anspruch 11 gelöst. Vorteilhafte Ausgestaltungen und weitere Ausführungsbeispiele sind in den abhängigen Ansprüchen beschrieben.

Eine Solarmodulkonstruktion nach der vorliegenden Erfindung umfasst wenigstens eine pyramidenförmige Trägereinheit und an der Trägereinheit vorgesehene photovoltaische Einheiten. Die Trägereinheit weist eine dreieckförmige Basis und dreieckförmige Seitenflächen auf. Die Trägereinheit ist als Trägerrahmen ausgebildet, der mittels Basisstreben die dreieckförmige Basis und mittels Seitenstreben die Seitenflächen aufspannt. Der Zwischenraum zwischen den Basis- bzw. Seitenstreben ist offen. Vorteilhaft ist die Basis als gleichschenkliges Dreieck und vorzugsweise als gleichseitiges Dreieck ausgelegt. Die Seitenflächen sind vorteilhaft als gleichschenklige Dreiecke vorgesehen. Sie können aber auch eine andere dreieckige Geometrie aufweisen, solange der Trägerrahmen insgesamt eine Pyramidenform bildet. Der Trägerrahmen kann somit eine gerade oder eine schiefe Pyramide bilden. Die Katheten der drei Seitenflächen treffen sich in einem Punkt, welche die Spitze der Pyramide und somit einen Kopfbereich der Trägereinheit und der Solarmodulkonstruktion bildet.

Wenigstens eine der Seitenflächen ist mit einem flexiblen Material überspannt, wobei das flexible Material eine der folgenden Eigenschaften aufweist: transparent, reflektierend, strukturiert, schallabsorbierend. Vorzugsweise sind alle drei Seitenflächen mit einem flexiblen Material überspannt. Der Zwischenraum zwischen den Basis- bzw. Seitenstreben ist somit durch das flexible Material überdeckt. Das Material kann durch Haltemittel an der Basis befestigt werden, so dass sie relativ zur Trägereinheit fixiert ist.

Als flexibles Material wird vorzugsweise eine flexible Membran, wie etwa eine Folie, vorgesehen. Die Membran kann z. B. über den Kopfbereich der Trägereinheit entlang der Seitenflächen bis zu den Basisstreben gezogen und befestigt werden. Eine Membran als flexibles Material hat den Vorteil, dass sie ein geringes Gewicht aufweist und leicht formbar ist. Auch kann eine dehnbare Membran verwendet werden, da sich leicht an eine Form der Seitenflächen anpassen lässt.

Das flexible Material kann aber auch durch eine dünne Platte gegeben sein, die derart dünn ist, dass sie biegsam und somit flexibel ist. Eine solche Platte ist aufgrund der Biegsamkeit nicht als alleiniger Träger geeignet, sondern bedarf der Trägereinheit, um eine stabile Basis für die photovoltaischen Einheiten zu bilden. Der Vorteil einer solchen Platte liegt in einem geringen Gewicht, einer leichten Bearbeitung und einem einfachen Montieren auf der Trägereinheit.

Die photovoltaischen Einheiten sind zumindest an einer der Seitenflächen der Trägereinheit vorgesehen. Für eine gute Energieausbeute pro Fläche, die mit einer Solarmodulkonstruktion überdeckt ist, werden vorteilhaft alle Seitenflächen mit photovoltaischen Einheiten versehen. Die photovoltaischen Einheiten sind in Form von flexiblen Solarmodulen auf dem flexiblen Material angebracht. Als flexible Solarmodule werden z. B. Dünnschichtsolarzellen verwendet, die auf einer flexiblen Folie aufgebracht sind. Nach der Erfindung wird zunächst das flexible Material, vorzugsweise eine Membran, auf dem Trägerrahmen befestigt und anschliessend werden die photovoltaischen Einheiten auf der Membran appliziert. Die Membran kann somit präzise über den Seitenflächen positioniert, gebogen, nötigenfalls auch gedehnt und verspannt werden, ohne dass die Solarmodule beschädigt werden. Die Solarmodule werden auf dem bereits fixierten flexiblen Material relativ zur Geometrie des Trägerrahmens positioniert und können somit in einfacher Weise optimal angeordnet werden.

Die flexible Membran kann aus einem Membranelement bestehen, das die drei Seitenflächen des pyramidenförmigen Trägerrahmens vollflächig überspannt. Somit können alle drei Seitenflächen gleichzeitig überdeckt werden und es sind nicht mehrere Einzelschritte zum Bespannen einzelner Seitenflächen erforderlich. Vorzugsweise ist das Membranmaterial dehnbar, sodass das Membranelement beim Aufziehen auf den Trägerrahmen verformt und an die Geometrie des Trägerrahmens angepasst werden kann. Insbesondere kann die Membran durch den Kopfbereich des Trägerrahmens ausgebeult werden, so dass sich die Membran straff über die Seitenflächen spannt. Alternativ zu einer vollflächigen Überspannung aller drei Seitenflächen können die Seitenflächen der Solarmodulkonstruktion mit einem Membranelement jeweils einzeln überspannt sein.

Die Solarmodulkonstruktionen können somit in einfacher Weise und schnell auf Vorrat produziert werden. Dabei können die Solarmodulkonstruktionen gestapelt werden, so dass sie bei der Lagerung und beim Transport trotz der dreidimensionalen Konstruktion wenig Raum einnehmen.

Eine Vielzahl derartiger nebeneinander angeordneter Solarmodulkonstruktionen kann ein Solarmodulfeld nach der vorliegenden Erfindung bilden. Die Solarmodulkonstruktionen können dabei einzeln installiert oder auf gemeinsamen Trägern angebracht werden. Durch die dreiseitige Pyramidenform kann sichergestellt werden, dass im Tagesverlauf immer eine Seitenfläche der Sonneneinstrahlung ausgesetzt ist und zur Energiegewinnung beiträgt. Für die Energiegewinnung ist es vorteilhaft Solarmodulkonstruktionen zu verwenden, die an allen drei Seitenflächen mit photovoltaischen Einheiten ausgestattet sind. Das Solarmodulfeld kann jedoch auch andere Anwendungen haben, wie nachfolgend gezeigt wird, bei welchen es vorteilhaft sein kann nur eine oder zwei der Seitenflächen mit Solarmodulen zu versehen.

Bei einer bevorzugten Ausgestaltung eines Solarmodulfeldes nach der Erfindung ist das Feld aus einer Vielzahl von Solarmodulpaaren aufgebaut, wobei ein Solarmodulpaar durch zwei nebeneinander angeordnete Solarmodulkonstruktionen gebildet wird, bei dem die Basen der Solarmodulkonstruktionen aneinander angrenzen und gemeinsam ein Parallelogramm bilden. Daraus ergibt sich, dass die sechs Seitenflächen des Solarmodulpaares in sechs unterschiedliche Richtungen ausgerichtet sind. Die sechs verschiedenen Richtungen der Seitenflächen können die Ausrichtung der Solarmodule der Solarmodulpaare relativ zur Sonne optimieren und die Energiegewinnung kann erhöht werden. Ferner können die Solarmodulpaare in jeweils gleicher Orientierung bündig aneinander gereiht werden und ergeben dabei eine gerade Linie, wodurch der Aufbau des Solarmodulfeldes und dessen Montage und Wartung vereinfacht wird.

Bei einer vorteilhaften Geometrie einer erfindungsgemässen Solarmodulkonstruktion bildet die Basis des pyramidenförmigen Trägerrahmens ein gleichseitiges Dreieck und die Seitenflächen schliessen an einem Kopfbereich des Trägerrahmens einen Winkel zwischen 50° und 70°, vorzugsweise von 60° ein. Der Kopfbereich ist somit nur gering von der Basisfläche des Trägerrahmens abgehoben. Die Seitenflächen bilden somit nur eine geringe Windangriffsfläche und weisen eine bevorzugte Winkeleinstellung zur Sonneneinstrahlung auf.

Das flexible Material kann gezielt nach gewünschten Eigenschaften ausgewählt werden, wobei das Material transparent, reflektierend, strukturiert, schallabsorbierend oder eingefärbt ist. Bei grossflächigen Solarmodulfeldern kann das Feld somit eine zusätzliche Funktion übernehmen, wie etwa Beschattung, Schallschutz, Überdachung, usw..

Im Fall von einzeln bespannten Seitenflächen der Solarmodulkonstruktion können die Seitenflächen jeweils mit unterschiedlichen Materialien überspannt sein. Somit können die Seitenflächen der Solarmodulkonstruktion unterschiedliche Eigenschaften aufweisen. Die Auswahl der Materialeigenschaften kann entsprechend der Ausrichtung der Solarmodulkonstruktion an einem Einsatzort gewählt werden. Beispielsweise können dunkle Membranen für nach Süden ausgerichtete Seitenflächen und schallabsorbierende Membrane für Seitenflächen gewählt werden, die zu verkehrsreichen Strassen hin ausgerichtet sind.

Für eine hohe Energieausbeute pro Fläche, die mit einer Solarmodulkonstruktion überdeckt ist, werden die Seitenflächen möglichst vollständig mit photovoltaischen Einheiten besetzt. Es können aber auch Solarmodulkonstruktionen vorgesehen werden, bei welchen eine mit Solarmodulen versehene Seitenfläche einen Bereich mit flexiblen Solarmodulen und einen freien Bereich ohne Solarmodule aufweist, wobei der freie Bereich wenigstens 10% der Seitenfläche beträgt, vorzugsweise zwischen 20% und 35%. Der freie Bereich ermöglicht z. B. einen Lichtdurchgang, um die mit Solarmodulkonstruktionen bedeckte Fläche, bzw. die mit einem Solarmodulfeld überdeckte Fläche, ausreichend mit Lichteintritt zu versorgen. Dies kann z. B. bei der Verwendung von Solarmodulfeldern nach der Erfindung vorteilhaft sein, die auf oder an Gewächshäusern vorgesehen sind oder die ein Dach eines Gewächshauses bilden.

Bei einer weiteren vorteilhaften Ausführungsform einer Solarmodulkonstruktion nach der Erfindung kann die Membran oder die Platte perforiert sein. An solarmodul-freien Bereichen der Seitenflächen kann dadurch ein Austausch zwischen Innen- und Aussenseite der Solarmodulkonstruktion entstehen. Beispielsweise kann ein Austausch von Feuchtigkeit nach aussen und von Frischluft nach innen erfolgen. Auch kann z. B. Regenwasser zumindest teilweise durch die Solarmodulkonstruktion hindurchtreten.

Weiter kann die Membran oder die Platte eine Armierung aufweisen, wodurch die Stabilität der Seitenflächen erhöht wird. Die Armierung kann bereits vor dem Aufziehen auf den Trägerrahmen am flexiblen Material vorgesehen sein oder erst danach angebracht werden. Vorzugsweise wird eine Netzarmierung verwendet, die eine Stabilisierung in zwei verschiedenen Dimensionen ermöglicht.

Der Trägerrahmen der Solarmodulkonstruktion ist vorzugsweise modular aufgebaut, wobei die Basisstreben, die Seitenstreben und Eckverbinder als einheitliche Module zum Zusammenbauen des Trägerrahmens vorliegen. Die Eckverbinder dienen zum Verbinden der Basisstreben und der Seitenstreben und zum Fixieren des flexiblen Materials, insbesondere der Membran über den Seitenstreben an der Basis. Vorzugsweise weisen auch die Basisstreben Haltemittel zum Halten des Materials auf, wie etwa Klemmschienen oder Klebeflächen. Vorzugsweise ist auch ein Kopfverbinder zum Verbinden der Seitenstreben am Kopfbereich des Trägerrahmens vorgesehen, der im Kopfbereich der Solarmodulkonstruktion zumindest teilweise über der Membran an den Seitenstreben angebracht ist. Dadurch werden die Seitenstreben in Position gehalten und gleichzeitig die Membran fixiert.

Für eine vorteilhafte Ausgestaltung eines Solarmodulfelds nach der vorliegenden Erfindung sind mehrere parallel verlaufende Trägerbalken zum Tragen der Solarmodulkonstruktionen vorgesehen. Dabei tragen jeweils zwei parallele Trägerbalken mehrere Solarmodulkonstruktionen, insbesondere Solarmodulpaare, wie oben beschrieben. Die Solarmodulkonstruktion, bzw. Solarmodulpaare sind vorzugsweise aneinander anliegend in Reihe auf den Trägerbalken vorgesehen. Mehrere solcher Reihen sind aneinander anliegend parallel angeordnet, so dass das Solarmodulfeld eine geschlossene Fläche bilden kann. Die Trägerbalken können auch eine Montageschiene aufweisen, so dass z. B. ein Montagewagen auf den parallelen Schienen zweier paralleler Trägerbalken über den Solarmodulkonstruktionen fahren kann. Dies erlaubt eine einfache Bestückung der Trägerbalken mit Solarmodulkonstruktionen und eine einfache Wartung der Solarmodulkonstruktionen eines Solarmodulfeldes. Die Trägerbalken können in ihrer Höhe an das Einsatzgebiet des Solarmodulfeldes angepasst werden. Ferner kann mittels der Trägerbalken die Neigung eines Solarmodulfeldes relativ zur überdeckten Oberfläche, bzw. relativ zur Sonneneinstrahlung eingestellt werden.

Die Erfindung wurde an Hand mehrerer Ausführungsbeispiele dargestellt. Die einzelnen technischen Merkmale eines Beispiels können durchaus auch in Kombination mit einem anderen Beispiel mit den dargelegten Vorteilen verwendet werden. Die Beschreibung der erfindungsgemässen technischen Merkmale ist daher nicht zwingend auf das jeweilige Ausführungsbeispiele beschränkt.

Vorteilhafte Ausführungsformen der Erfindung werden im Folgenden anhand der Zeichnungen dargestellt, die lediglich zur Erläuterung dienen und nicht einschränkend auszulegen sind. Aus den Zeichnungen offenbar werdende Merkmale der Erfindung sollen einzeln und in jeder Kombination als zur Offenbarung der Erfindung gehörend betrachtet werden. In den Zeichnungen zeigen:
- Fig. 1a: eine Ansicht von oben auf einen Trägerrahmen einer Solarmodulkonstruktion nach einer Variante der vorliegenden Erfindung,
- Fig. 1b: eine seitliche Ansicht auf den Trägerrahmen aus Figur 1a ohne Membran,
- Fig. 2: eine seitliche Ansicht auf eine andere Seite des Trägerrahmens aus Figur 1a mit Membran,
- Fig. 3: eine schematische Darstellung einer Seitenfläche einer Solarmodulkonstruktion nach der vorliegenden Erfindung mit Solarmodulen,
- Fig. 4: eine Ansicht von oben auf eine Variante einer Solarmodulkonstruktion auf parallel verlaufenden Trägerbalken nach der vorliegenden Erfindung,
- Fig. 5: eine schematische Darstellung einer Variante eines Solarmodulpaares nach der vorliegenden Erfindung,
- Fig. 6: eine schematische Darstellung einer Variante eines Solarmodulfeldes mit Solarmodulpaaren gemäss Figur 5 nach der vorliegenden Erfindung,
- Fig. 7: eine seitliche Ansicht auf das Solarmodulfeld mit Solarmodulpaaren gemäss Figur 6,
- Fig. 8: eine schematische Darstellung einer weiteren Variante eines Solarmodulfeldes nach der vorliegenden Erfindung,
- Fig. 8a: eine schematische Darstellung der Ausrichtung von Seitenflächen einer ersten Solarmodulkonstruktion eines Solarmodulpaares des Solarmodulfeldes aus Figur 8,
- Fig. 8b: eine schematische Darstellung der Ausrichtung von Seitenflächen einer zweiten Solarmodulkonstruktion eines Solarmodulpaares des Solarmodulfeldes aus Figur 8,
- Fig. 9: eine schematische Darstellung einer ersten Anwendung eines Solarmodulfeldes nach der vorliegenden Erfindung über Eisenbahngleisen und
- Fig. 10: eine schematische Darstellung einer zweiten Anwendung eines Solarmodulfeldes nach der vorliegenden Erfindung bei einem Gewächshaus.

Zwar wird die Erfindung nachfolgend an Beispielen mit einer flexiblen Membran als flexibles Material genauer erläutert. Es wird jedoch betont, dass auch eine flexible Platte als flexibles Material verwendet werden kann, wie vorher ausgeführt.

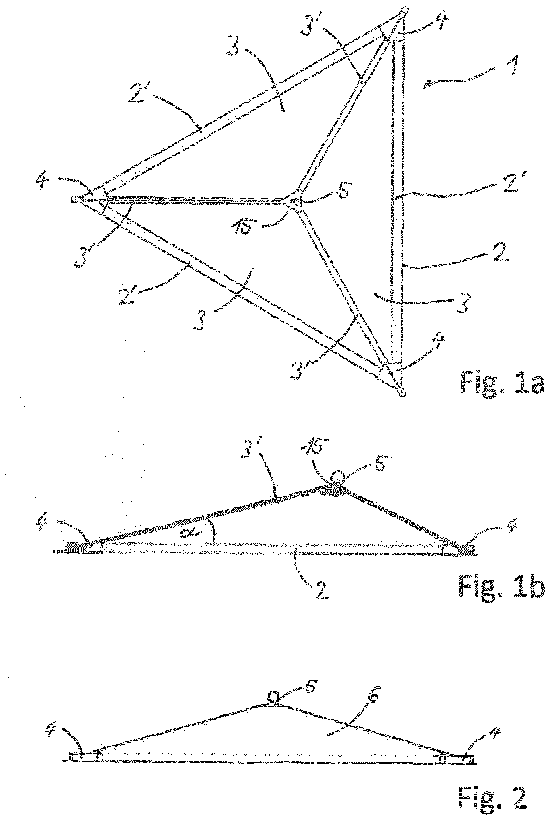

In den Figuren 1a und 1b ist eine Trägereinheit einer Solarmodulkonstruktion nach der vorliegenden Erfindung gezeigt, die als Trägerrahmen 1 ausgebildet ist. Der Trägerrahmen 1 umfasst Basisstreben 2', die eine dreieckige Basis 2 aufspannen. Im gezeigten Ausführungsbeispiel ist die Basis als gleichseitiges Dreieck ausgebildet und die drei Basisstreben 2' sind somit gleich lang. Von einer Basisstrebe 2' und jeweils zwei Seitenstreben 3' werden Seitenflächen 3 aufgespannt. Die Seitenstreben 3' sind in dem gezeigten Ausführungsbeispiel gleich lang, so dass die Seitenflächen als gleichseitiges Dreieck ausgebildet sind. Die Basisstreben 2' und die Seitenstreben 3' sind an den Ecken durch Eckverbinder 4 und die drei Seitenstreben 3' sind durch einen Kopfverbinder 5 in einem Kopfbereich 15 des Trägerrahmens 1 zusammengefügt. Der Trägerrahmen 1 bildet eine dreidimensionale pyramidenförmige Trägereinheit mit drei gleich grossen Seitenflächen 3.

Grundsätzlich kann die Pyramidengeometrie aber auch Seitenflächen unterschiedlicher Grösse aufweisen und die Basis- bzw. Seitenstreben müssen nicht die gleiche Länge aufweisen. Eine Basis in Form eines zumindest gleichschenkligen Dreiecks wird bevorzugt, damit sich beim Zusammenfügen zweier Solarmodulkonstruktionen zu einem Solarmodulpaar ein Parallelogramm ergibt, wie später genauer erläutert wird.

In Figur 1b ist der Trägerrahmen 1 von der Seite gezeigt. Daraus wird ersichtlich, dass sich die Seitenstreben 3' aus der von der Basis 2 aufgespannten Fläche abheben. In der gezeigten Ausführungsform stehen die Seitenstreben 3' in einem Winkel α von 26° von der Fläche der Basis 2 ab. Es können aber auch andere Winkel und unterschiedliche Winkel für die verschiedenen Seitenstreben gewählt werden, je nach Anwendungsgebiet und Orientierung der Grundfläche, auf der die Solarmodulkonstruktionen verwendet werden.

In Figur 2 ist der Trägerrahmen 1 mit einer flexiblen Membran 6 bespannt. Die Membran 6 ist in diesem Ausführungsbeispiel als Membranelement ausgebildet, das über die drei Seitenflächen 3 des pyramidenförmigen Trägerrahmens 1 gespannt wird und mittels der Eckverbinder 4 auf dem Trägerrahmen 1 befestigt wird. Zusätzlich kann die Membran über die Aussenseiten der Basisstreben gezogen und entlang der Basisstreben befestigt werden. Weiter kann die Membran durch den Kopfverbinder an den Seitenstreben 3' befestigt werden. Hierfür kann ein erstes Kopfverbinderelement von oben und ein zweites Kopfverbinderelement von unten angesetzt werden. Erstes und zweites Kopfverbinderelement werden miteinander verbunden, z. B. verschraubt, wobei sie die Membran zwischen sich einklemmen und die Seitenstreben 3' fixieren. Auf dem ersten Kopfverbinderelement kann ein Haken oder eine Öse nach oben abstehen, der zum Greifen und Transportieren der Solarmodulkonstruktion dienen kann.

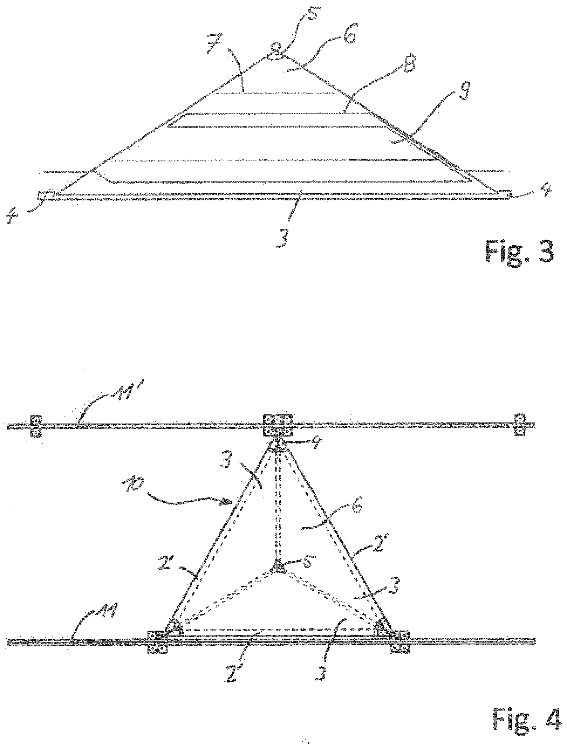

In Figur 3 ist eine Seitenfläche 3 der Solarmodulkonstruktion gezeigt, auf der photovoltaische Einheiten in Form von flexiblen Solarmodulen 7 auf der Membran 6 angebracht sind. Die Solarmodule 7 werden z. B. von photovoltaisch aktiven Wafern gebildet. Es werden z. B. 60 Solarmodule 7 in Reihen neben und parallel zueinander angeordnet und in herkömmlicher Weise miteinander mit einer Verkabelung 8 verkabelt, so dass Sonnenenergie eingefangen und in elektrische Energie umgewandelt und abgeführt werden kann. Wie in Figur 3 zu sehen ist weist die Seitenfläche 3 einen Bereich auf, der mit Solarmodulen 7 abgedeckt ist, und auch einen freien Bereich 9 ohne Solarmodule, wobei die Bereiche nicht zusammenhängend sein müssen. Der freie Bereich 9 entspricht in dem dargestellten Beispiel ca. 20% der Seitenfläche 3. Die Wafer können eine Vorderfolie, z. B. ETFE Folie, und eine Hinterfolie, z. B. als modifizierte Polyamidfolie, aufweisen, die gemeinsam die Folienbasis für die Solarmodule 7 bilden. Die Wafer, z. B. Siliziumwafer, werden zwischen der Vorder- und der Hinterfolie inklusive einer Verdrahtung für eine Verkabelung 8 laminiert. Die Solarmodule 7 können zu einem photovoltaischen Flächenmodul mittels der Folienbasis zusammengefasst werden und gemeinsam durch Anbringen auf die Membran aufgebracht werden. Je nach verwendetem Material können verschiedene Verbundtechniken verwendet werden, z. B. Kleben, Nähen, Laminieren, Vulkanisieren oder Nieten.

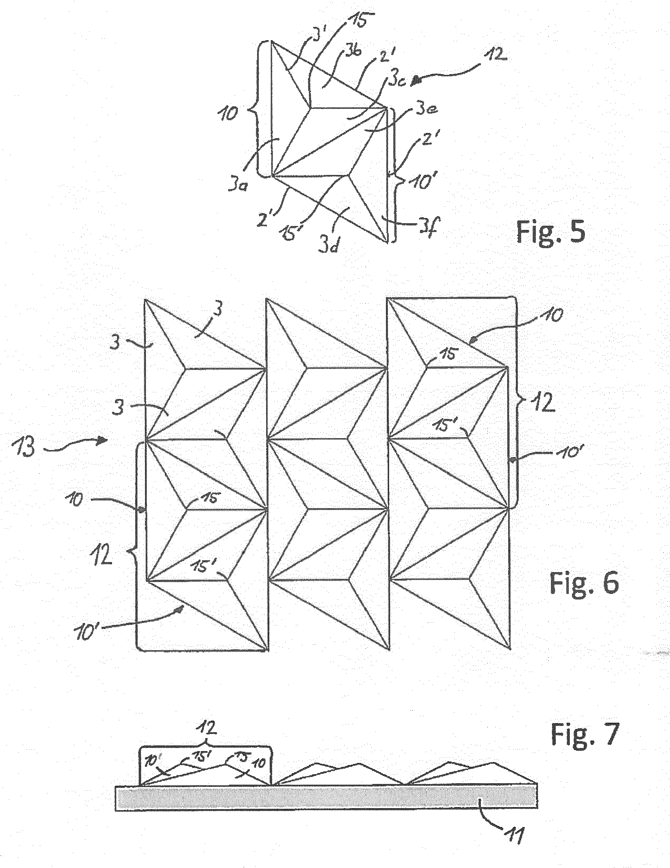

In Figur 4 ist eine Solarmodulkonstruktion 10 nach der vorliegenden Erfindung gezeigt, die wie vorher beschrieben ausgebildet ist. Die Solarmodule 7 wurden zu Gunsten einer besseren Übersicht in der Darstellung jedoch weggelassen. Die Solarmodulkonstruktion 10 ist auf zwei parallel verlaufenden Trägerbalken 11, 11' aufgesetzt und an den Ecken der Basis 2 auf diesen befestigt. Dabei verläuft eine der Basistreben 2' parallel zu einem Trägerbalken 11 und die beiden anderen Basisstreben 2' ragen vom Trägerbalken 11 zum Trägerbalken 11'. Die Ecken der parallel verlaufenden Basisstrebe 2' liegen somit auf dem Trägerbalken 11. Die Ecke der Basis, die der parallel verlaufenden Basisstrebe 2' gegenüberliegt, liegt somit auf dem anderen Trägerbalken 11' auf. Aufgrund der symmetrischen Geometrie der Solarmodulkonstruktion 10 kann eine weitere Solarmodulkonstruktion 10' (siehe Figur 5) um 180° gedreht neben der dargestellten Solarmodulkonstruktion 10 derart aufgesetzt werden, dass die Basisstreben der beiden Solarmodulkonstruktionen parallel aneinander zu liegen kommen können. Grundsätzlich ist es dabei auch denkbar, dass eine Basisstrebe für beide Solarmodulkonstruktionen 10 und 10' gemeinsam verwendet wird und die gemeinsame Basisstrebe zu den beiden angrenzenden Basen gehört. Zwei derart zueinander angeordnete Solarmodulkonstruktionen bilden ein Solarmodulpaar, wie nachfolgend genauer erläutert wird. Das Solarmodulpaar wird von einer Art Doppelpyramide gebildet.

In Figur 5 ist ein solches Solarmodulpaar 12 mit einer ersten Solarmodulkonstruktion 10 und einer dazu um 180° gedrehten, zweiten Solarmodulkonstruktion 10' gezeigt. Das Solarmodulpaar 12 überspannt ein Parallelogramm mit den Seitenlängen der Basisstreben 2'. Der Abstand der sich gegenüberliegenden Basisstreben 2' entspricht dabei vorteilhafter Weise dem Abstand der parallel verlaufenden Trägerbalken 11 und 11', wie in Figur 4 gezeigt. Auch hier wurden die Solarmodule 7 für eine bessere Übersichtlichkeit nicht gezeigt. Das Solarmodulpaar 12 weist sechs Seitenflächen 3, die jeweils in unterschiedliche Richtungen orientiert sind. Zur Solarmodulkonstruktion 10 gehören die Seitenflächen 3a, 3b und 3c. Zur Solarmodulkonstruktion 10' gehören die Seitenflächen 3d, 3e und 3f.

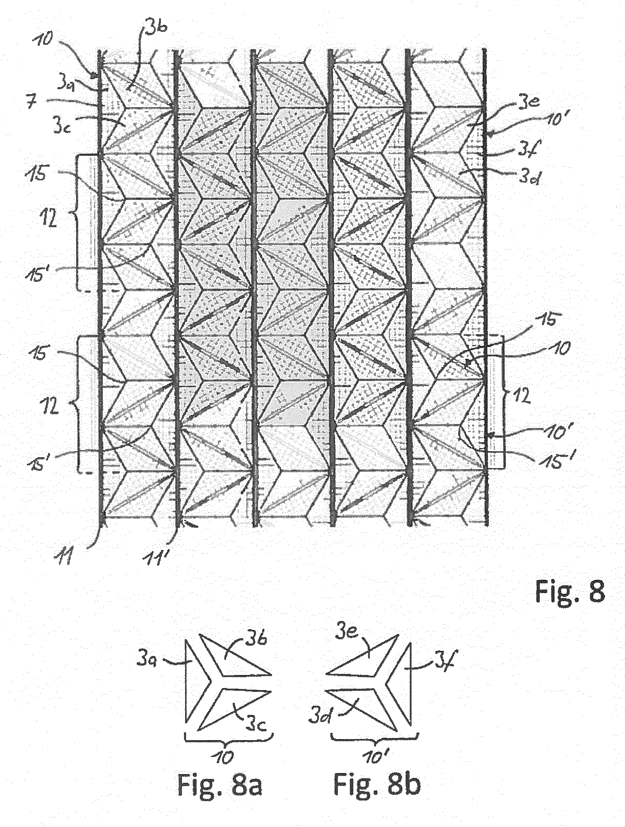

In Figur 6 ist schematisch ein Solarmodulfeld 13 nach der vorliegenden Erfindung gezeigt, das aus Solarmodulpaaren gemäss Figur 5 aufgebaut ist. Hierfür werden die Solarmodulkonstruktionen 10 einzeln oder als Solarmodulpaare 12 in Reihe auf den Trägerbalken 11, 11' montiert. Es sind drei parallel angeordnete Reihen von Solarmodulpaaren gezeigt. Jede Reihe ist mit zwei Solarmodulpaaren 12 dargestellt, obgleich in real verwendeten Solarmodulfeldern in der Regel mehr als zwei Solarmodulpaare verwendet werden, wie z. B. aus Figur 8 ersichtlich wird. Die Solarmodulpaare 12 einer Reihe stossen mit ihren Basen derart aneinander an, dass sich ein Streifen von Solarmodulkonstruktionen ergibt, der eine gemeinsame geradlinige Achse aufweist. Der Rand der aneinander gereihten Solarmodulpaare bildet zu beiden Seiten eine kontinuierliche gerade Kante, die auf den Trägerbalken aufliegt. Die einzelnen Reihen können beliebig zu einander verschoben angeordnet werden. Ein optisch gefälliger Eindruck entsteht z. B., wenn die Solarmodulpaare 12 mit gleicher Orientierung in nebeneinander liegenden Reihen auf gleicher Höhe angeordnet werden.

In Figur 7 ist das Solarmodulfeld 13 in einer Seitenansicht auf eine Reihe von Solarmodulpaaren 12 mit einem Schnitt durch einen Trägerbalken 11 gezeigt. Aus der Ansicht wird ersichtlich, dass der Kopfbereich 15 der Solarmodulkonstruktion 10 und der Kopfbereich 15' der Solarmodulkonstruktion 10' zueinander versetzt sind. Die Solarmodulkonstruktion 10 und 10' hintereinander liegender Solarmodulpaare 12 fluchten in Figur 7, so dass jeweils nur ein Solarmodulpaar 12 zu sehen ist.

In Figur 8 ist ein Beispiel eines Solarmodulfeldes 13 gezeigt, das z. B. als Überdachung von Bahngleisen dienen kann. Es sind fünf parallel verlaufende Reihen von Solarmodulpaaren 12 gezeigt, die auf Trägerbalken 11, 11' montiert sind. Die Solarmodulpaare 12 einer Reihe sind wie in Figur 6 gezeigt, aneinander anschliessend aufgereiht. In Figur 8 sind zudem die Solarmodule 7 gezeigt, die auf den Seitenflächen 3 der Solarmodulkonstruktionen 10 und 10' der Solarmodulpaare 12 angeordnet sind. Zu einem Solarmodulpaar 12 gehören die sechs Seitenflächen 3a, 3b, 3c, 3d, 3e und 3f der Solarmodulkonstruktionen 10 und 10', wie auch aus Figur 5 ersichtlich ist. In dem gezeigten Beispiel ist die Seitenfläche 3a nach West, die Seitenfläche 3b nach Nord-Ost, die Seitenfläche 3c nach Süd-Ost, die Seitenfläche 3d nach Süd-West, die Seitenfläche 3e nach Nord-West und die Seitenfläche 3f nach Ost ausgerichtet. In Richtung Süden sind somit die Seitenflächen 3c und 3d vorgesehen und in Richtung Norden die Seitenflächen 3b und 3e. Somit ergibt sich für alle Richtungen eine für die Energiegewinnung gute Orientierung der Seitenflächen.

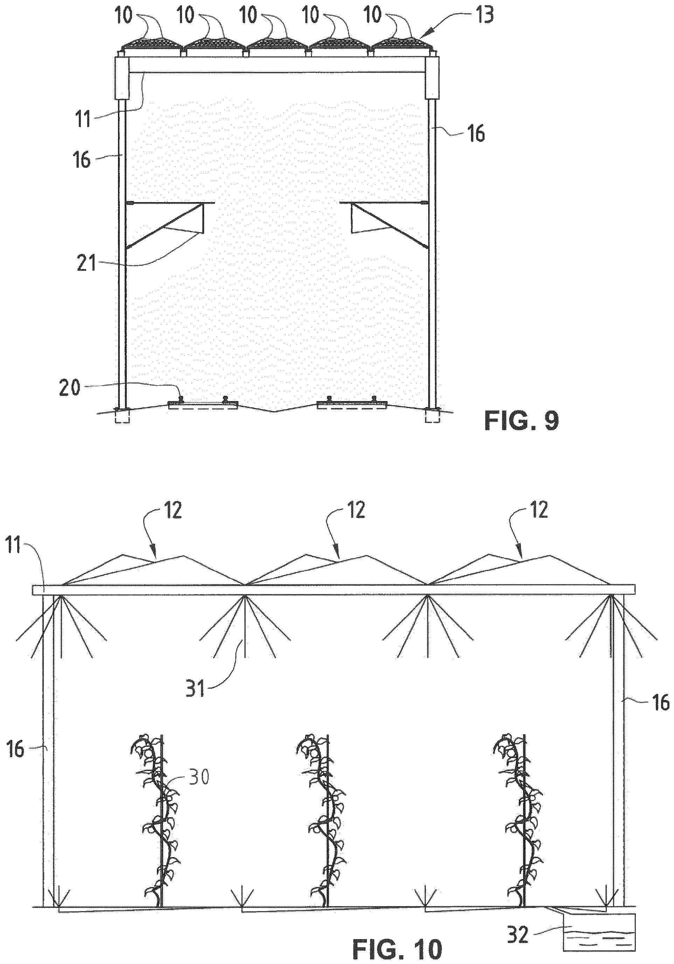

In Figur 9 ist eine erste Anwendung eines Solarmodulfelds mit Solarmodulkonstruktionen nach der vorliegenden Erfindung als Überdachung von Bahngleisen 20 und zugehörigen Oberleitungen 21 gezeigt. Die Trägerbalken 11 werden von Pfählen 16 getragen und über den Oberleitungen angeordnet. Entlang der Trägerbalken 11 ist beispielhaft eine Reihe von Solarmodulkonstruktionen 10 gezeigt, die zu Solarmodulpaaren, wie vorher beschrieben gehören. Es sind mehrere Reihen von Solarmodulpaaren vorgesehen, die gemeinsam ein Solarmodulfeld 13 bilden, wie es z. B. in Figur 8 gezeigt ist. Die Solarmodulkonstruktionen 10 sind bei dieser Anwendung z. B. mit einer Membran bespannt, die wasserundurchlässig und leicht opak ist. Die Solarmodulkonstruktionen 10 können mittels einer Abdichtung derart auf den Trägerbalken 11 montiert werden, dass kein Wasser zwischen Trägerbalken und Solarmodulkonstruktion hindurchdringen kann. Das Solarmodulfeld 13 schützt die von ihr abgedeckte Fläche somit gegen Niederschlag.

In Figur 10 ist eine zweite Anwendung eines Solarmodulfelds 13 mit Solarmodulpaaren 12 nach der Erfindung gezeigt, dass als Überbauung einer Bepflanzung 30 dient. Die Solarmodulpaare 12 sind wiederum auf Trägerbalken 11 befestigt, die ihrerseits auf Pfählen 16 gelagert sind. Bei dieser Anwendung ist es vorteilhaft eine perforierte und transparente Membran zu verwenden, so dass z. B. Regenwasser zur Bewässerung 31 durch die Membran hindurchtreten kann. Auf den Seitenflächen werden vorzugsweise grössere Solarmodul-freie Bereiche vorgesehen, beispielsweise 25% bis 35% der Seitenfläche, um eine Besonnung der Bepflanzung 30 zu ermöglichen. Auch kann das Regenwasser in einem Auffangbecken 32 gesammelt und der Bepflanzung 30 zugeführt werden. Zum Betrieb einer solchen Bewässerung kann z. B. die mit dem Solarmodulfeld 13 gewonnen elektrische Energie verwendet werden, so dass sich eine energieneutrale Bepflanzungsanlage ergibt. Grundsätzlich kann das Auffangbecken 32 auch mit Grundwasser befüllt werden.

Ein Solarmodulfeld, wie bisher beschrieben, kann auch in Verbindung mit einem Luftentfeuchter vorgesehen werden. Beispielsweise kann der Luftentfeuchter durch die vom Solarmodulfeld gewonnene Energie betrieben werden. Der Luftentfeuchter kann z. B. zur Wassergewinnung genutzt werden, indem das abgeschiedene Wasser gesammelt und anderweitig verwendet wird. Beispielsweise kann das Wasser zur Bewässerung eines Gewächshauses genutzt werden. Es kann z. B. ein Luftentfeuchter auf der Basis von Luftkühlung mit Wasserausscheidung durch die mit dem Solarmodulfeld erzeugte Energie betrieben werden. Es können aber auch andere Entfeuchtungskonzepte zur Anwendung kommen, je nach den klimatischen Bedinungen des Umfelds.

**Bezugszeichen**

| | | | |
|---|---|---|---|
| 1 | Trägerrahmen | 12 | Solarmodulpaar |
| 2 | Basis | 13 | Solarmodulfeld |
| 2' | Basisstreben | 15 | Kopfbereich |
| 3 | Seitenfläche | 16 | Pfahl |
| 3' | Seitenstreben | | |
| 4 | Eckverbinder | 20 | Bahngleis |
| 5 | Kopfverbinder | 21 | Oberleitung |
| 6 | Membran | 30 | Bepflanzung |
| 7 | Solarmodul | 31 | Bewässerung |
| 8 | Verkabelung | 32 | Auffangbecken |
| 9 | freier Bereich | | |
| 10, 10' | Solarmodulkonstruktion | α | Winkel Basisfläche Seitenstrebe |
| 11, 11' | Trägerbalken | | |

## Patentansprüche

1. Solarmodulkonstruktion, die wenigstens eine pyramidenförmige Trägereinheit mit einer dreieckförmigen Basis (2) und dreieckförmigen Seitenflächen (3) sowie zumindest an einer der Seitenflächen (3) der Trägereinheit vorgesehene photovoltaische Einheiten umfasst, **dadurch gekennzeichnet, dass**
- die Trägereinheit als Trägerrahmen (1) ausgebildet ist, der mittels Basisstreben (2') die dreieckförmige Basis (2) und mittels Seitenstreben (3') die Seitenflächen aufspannt,
- wenigstens eine der Seitenflächen (3) mit einem flexiblen Material überspannt ist, wobei das flexible Material eine der folgenden Eigenschaften aufweist: transparent, reflektierend, strukturiert, schallabsorbierend und
- die an zumindest einer Seitenfläche (3) photovoltaische Einheiten in Form von flexiblen Solarmodulen (7) auf dem flexiblen Material angebracht sind.

2. Solarmodulkonstruktion nach Anspruch 1, **dadurch gekennzeichnet, dass** das flexible Material aus einer flexiblen Membran (6) oder einer flexiblen Platte besteht.

3. Solarmodulkonstruktion nach Anspruch 1, **dadurch gekennzeichnet, dass** die flexible Membran (6) aus einem Membranelement besteht, das die drei Seitenflächen (3) des pyramidenförmigen Trägerrahmens (1) vollflächig überspannt.

4. Solarmodulkonstruktion nach Anspruch 1, **dadurch gekennzeichnet, dass** wenigstens zwei der Seitenflächen (3) mit unterschiedlichem flexiblem Material überspannt sind, wobei die unterschiedlichen flexiblen Materialien sich jeweils hinsichtlich der Eigenschaften unterscheiden.

5. Solarmodulkonstruktion nach einem der Ansprüche 1 bis 4, **dadurch gekennzeichnet, dass** die mit Solarmodulen (7) versehene Seitenfläche (3) einen Bereich mit flexiblen Solarmodulen (7) und einen freien Bereich (9) ohne Solarmodule aufweist, wobei der freie Bereich (9) wenigstens 10% der Seitenfläche beträgt, vorzugsweise zwischen 20% und 35%.

6. Solarmodulkonstruktion nach einem der vorhergehenden Ansprüche, **dadurch gekennzeichnet, dass** das flexible Material perforiert ist.

7. Solarmodulkonstruktion nach einem der vorhergehenden Ansprüche, **dadurch gekennzeichnet, dass** das flexible Material eine Armierung, insbesondere eine Netzarmierung, aufweist.

8. Solarmodulkonstruktion nach einem der vorhergehenden Ansprüche, **dadurch gekennzeichnet, dass** die Basis (2) des Trägerrahmens (1) ein gleichseitiges Dreieck bildet und die Seitenflächen (3) an einem Kopfbereich (15) des pyramidenförmigen Trägerrahmens (1) einen Winkel von 60° einschliessen.

9. Solarmodulkonstruktion nach einem der vorhergehenden Ansprüche, **dadurch gekennzeichnet, dass** der Trägerrahmen (1) modular aufgebaut ist aus den Basisstreben (2'), den Seitenstreben (3') und Eckverbindern (4), die zum Verbinden der Basisstreben (2') und der Seitenstreben (3') und zum Fixieren des flexiblen Materials über den Seitenstreben (3') an der Basis (2) vorgesehen sind.

10. Solarmodulkonstruktion nach Anspruch 9, **dadurch gekennzeichnet, dass** der modulare Trägerrahmen (1) einen Kopfverbinder (5) zum Verbinden der Seitenstreben (3') aufweist, der in einem Kopfbereich (15) der Solarmodulkonstruktion zumindest teilweise über der Membran (6) an den Seitenstreben (3') angebracht ist.

11. Solarmodulfeld, das aus einer Vielzahl von nebeneinander angeordneten Solarmodulkonstruktionen (10) nach einem der Ansprüche 1 bis 10 aufgebaut ist.

12. Solarmodulfeld nach Anspruch 11, **dadurch gekennzeichnet, dass** zwei nebeneinander angeordnete Solarmodulkonstruktionen (10; 10') ein Solarmodulpaar (12) bilden, bei dem die Basen (2) der Solarmodulkonstruktionen (10; 10') an einander angrenzen und gemeinsam ein Parallelogramm bilden.

13. Solarmodulfeld nach Anspruch 11 oder 12, **dadurch gekennzeichnet, dass** mehrere parallel verlaufende Trägerbalken (11; 11') zum Tragen der Solarmodulkonstruktionen (10) vorgesehen sind, wobei jeweils zwei parallele Trägerbalken (11; 11') mehrere Solarmodulpaare (12) aneinander anliegend in Reihe tragen und mehrere solcher Reihen nebeneinander angeordnet sind, so dass das Solarmodulfeld (13) eine geschlossene Fläche bildet.

## Claims

1. Solar module construction comprising at least one pyramidal support unit with a triangular base (2) and triangular lateral planes (3) as well as photovoltaic units provided on at least one of the lateral planes (3) of the support unit, **characterized in that**
- the support unit is designed as supporting frame (1), which spans the triangular base (2) by means of base struts (2') and the lateral planes by means of lateral struts (3'),
- at least one of the lateral planes (3) is stretched over with a flexible material, whereby the flexible material has one of the following features: transparent, reflecting, structured, sound-absorbent and
- the photovoltaic units on at least one lateral plane are attached in the form of flexible solar modules (7) on the flexible material.

2. Solar module construction according to claim 1, **characterized in that** the flexible material is made up of a flexible membrane (6) or a flexible plate.

3. Solar module construction according to claim 1, **characterized in that** the flexible membrane (6) is made up of a membrane element, which stretches over the three lateral planes (3) of the pyramidal supporting frame (1) completely.

4. Solar module construction according to claim 1, **characterized in that** at least two of the lateral planes (3) are stretched over with different flexible material, whereby the different flexible materials differ in each case with respect to the features.

5. Solar module construction according to one of the claims 1 to 4, **characterized in that** the lateral plane (3) provided with solar modules (7) has a region with flexible solar modules (7) and a free region (9) without solar modules, the free region (9) amounting to at least 10% of the lateral plane, preferably between 20% and 35%.

6. Solar module construction according to one of the preceding claims, **characterized in that** the flexible material is perforated.

7. Solar module construction according to one of the preceding claims, **characterized in that** the flexible material has a reinforcement, in particular a mesh reinforcement.

8. Solar module construction according to one of the preceding claims, **characterized in that** the base (2) of the supporting frame (1) forms an equilateral triangle and the lateral planes (3) enclose an angle of 60° on a head region (15) of the pyramidal supporting frame (1).

9. Solar module construction according to one of the preceding claims, **characterized in that** the supporting frame (1) is constructed modularly from the base struts (2'), the lateral struts (3') and corner connectors (4), which are provided for connecting the base struts (2') and the lateral struts (3') and for fixing the flexible material over the lateral struts (3') to the base (2).

10. Solar module construction according to claim 9, **characterized in that** the modular supporting frame (1) has a head connector (5) for connecting the lateral struts (3'), which is installed on the lateral struts (3') at least partially over the membrane (6) in a head region (15) of the solar module construction.

11. Solar module array, which is constructed from a multiplicity of adjacently disposed solar module constructions (10) according to one of the claims 1 to 10.

12. Solar module array according to claim 11, **characterized in that** two adjacently disposed solar module constructions (10; 10') form a solar module pair (12), in which the bases (2) of the solar module constructions (10; 10') abut one another and form together a parallelogram.

13. Solar module array according to claim 11 or 12, **characterized in that** a multiplicity of parallel-running support rods (11; 11') are provided for carrying the solar module constructions (10), whereby every two parallel support rods (11; 11') carry a multiplicity of solar module pairs (12) bordering on one another in rows, and a multiplicity of such rows are disposed next to one another so that the solar module array (13) has a closed surface.

## Revendications

1. Structure pour module solaire comprenant au moins un support pyramidal ayant une base triangulaire (2) et des surfaces latérales triangulaires (3), ainsi que des unités photovoltaïques prévues sur au moins une des surfaces latérales (3) du support, **caractérisée en ce que**
- Le support est conçu comme un cadre de support (1), qui étend la base triangulaire (2) au moyen de supports de base (2') et les surfaces latérales (3) au moyen d'entretoises latérales (3'),
- au moins l'une des surfaces latérales (3) est recouverte d'un matériau flexible, le matériau flexible présentant l'une caractéristiques suivantes: transparent, réfléchissant, structuré, insonorisant et
- des unités photovoltaïques sont montées sur le matériau flexible sous forme de modules solaires flexibles (7) sur au moins une surface latérale.

2. Structure pour module solaire selon la revendication 1, **caractérisée en ce que** le matériau flexible est constitué d'une membrane flexible (6) ou d'un panneau flexible.

3. Structure pour module solaire selon la revendication 1, **caractérisée en ce que** la membrane flexible (6) est constituée d'un élément de membrane, qui recouvre complètement les trois surfaces latérales (3) du cadre de support pyramidal (1).

4. Structure pour module solaire selon la revendication 1, **caractérisée en ce qu'**au moins deux des surfaces latérales (3) sont recouvertes de différents matériaux flexibles, les différents matériaux flexibles ayant respectivement des propriétés distinctes.

5. Structure pour module solaire selon l'une des revendications 1 à 4, **caractérisée en ce que** la surface latérale (3) pourvue de modules solaires (7) possède une zone avec modules solaires flexibles (7) et une zone libre (9) sans module solaire, la zone libre (9) représentant au moins 10% de la surface latérale, de préférence entre 20% et 35%.

6. Structure pour module solaire selon l'une des revendications précédentes, **caractérisée en ce que** le matériau flexible est perforé.

7. Structure pour module solaire selon l'une des revendications précédentes, **caractérisée en ce que** le matériau flexible est renforcé, en particulier via un treillis d'armature.

8. Structure pour module solaire selon l'une des revendications précédentes, **caractérisée en ce que** la base (2) du cadre de support (1) forme un triangle équilatéral, et que les surfaces latérales (3) forment un angle de 60° au niveau d'une zone de tête (15) du cadre de support pyramidal (1).

9. Structure pour module solaire selon l'une des revendications précédentes, **caractérisée en ce que** le cadre de support (1) est construit de manière modulaire par les supports de base (2'), les entretoises latérales (3') et les raccords d'angles (4), qui sont prévus pour connecter les supports de base (2') et les entretoises latérales (3') et pour fixer le matériau flexible au-dessus des entretoises latérales (3') à la base (2).

10. Structure pour module solaire selon la revendication 9, **caractérisée en ce que** le cadre de support (1) modulaire possède un connecteur de tête (5) pour interconnecter les entretoises latérales (3'), lequel est monté sur entretoises latérales (3') au moins partiellement sur la membrane (6) au niveau d'une zone de tête (15) de la construction de module solaire.

11. Réseau de module solaire, qui est formé par une multitude de structures pour module solaire selon l'une des revendications 1 à 10 disposées de manière adjacente (10) les unes aux autres.

12. Réseau de module solaire selon la revendication 11, **caractérisé en ce que** deux constructions de module solaire disposées de manière adjacente (10 ; 10') forment une paire de modules solaires (12), dans laquelle les bases (2) des constructions de module solaire (10 ; 10') se jouxtent mutuellement et forment ensemble un parallélogramme.

13. Réseau de module solaire selon la revendication 11 ou 12, **caractérisé en ce qu'**une multitude de poutres de support (11 ; 11 ') s'étendant parallèlement les unes aux autres sont prévues pour porter les constructions de module solaire (10), dans lequel respectivement deux poutres de support (11 ; 11') parallèles portent une multitude de paires de modules solaires (12) adjacents agencés en rang, et une multitude de tels rangs sont disposées les uns à côté des autres de telle sorte que le réseau de module solaire (13) présente une surface fermée continue.
